Europäisches Patentamt

European Patent Office

Office européen des brevets

(19)

(11) Numéro de publication: **0 070 211**
**A1**

(12) **DEMANDE DE BREVET EUROPEEN**

(21) Numéro de dépôt: **82401122.5**

(22) Date de dépôt: **18.06.82**

(51) Int. Cl.³: **H 01 L 29/72**
**H 01 L 29/08**

(30) Priorité: **26.06.81 FR 8112613**

(43) Date de publication de la demande:
**19.01.83 Bulletin 83/3**

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Nuyen, Trong Linh**
**THOMSON-CSF SCPI 173, bld Haussmann**
**F-75379 Paris Cedex 08(FR)**

(72) Inventeur: **Delagebeaudeuf, Daniel**
**THOMSON-CSF SCPI 173, bld Haussmann**
**F-75379 Paris Cedex 08(FR)**

(72) Inventeur: **Etienne, Patrick**
**THOMSON-CSF SCPI 173, bld Haussmann**
**F-75379 Paris Cedex 08(FR)**

(74) Mandataire: **Taboureau, James et al,**
**THOMSON-CSF SCPI 173, Bld Haussmann**
**F-75379 Paris Cedex 08(FR)**

(54) **Transistor balistique à multiples hétérojonctions.**

(57) L'invention concerne les semiconducteurs de type transistors, dont l'épaisseur de base est plus courte que le libre parcours moyen des électrons dans le matériau semiconducteur.

Les transistors selon l'invention ont une structure verticale et fonctionnent en régime balistique. Ils comportent, entre la couche N⁺ (1) de l'émetteur et la couche N (3) de base une couche supplémentaire de haute résistivité (2 ou 4) formant une hétérojonction de sorte que le transfert électronique soit en régime d'électrons chauds, par effet tunnel (couche 2) ou par effet thermoionique (couche 4) ou les deux effets combinés. Selon une variante, les transistors selon l'invention comportent en outre, entre collecteur et base, une autre couche supplémentaire de haute résistivité (5) formant une deuxième hétérojonction.

Application aux transistors hyperfréquences.

FIG.6

EP 0 070 211 A1

Croydon Printing Company Ltd.

TRANSISTOR BALISTIQUE A MULTIPLES HETEROJONCTIONS

La présente invention concerne les dispositifs à semiconducteurs de type transistor et plus particulièrement ceux dont l'épaisseur de la base est plus courte que le libre parcours moyen des électrons dans le matériau semiconducteur.

Dans la demande de brevet français n° 80.23 385, déposé par la demanderesse, est décrit un transistor dont le canal est constitué par une couche épitaxiale d'épaisseur plus faible que le libre parcours moyen des électrons dans cette couche, ce transistor étant réalisé de telle sorte que l'épaisseur de ladite couche corresponde à la longueur de la grille du transistor. La structure de ce transistor comporte une superposition de couches $N^+/N/N^+$ réalisées par épitaxie.

Ce transistor constitue un progrès par rapport à l'art antérieur mais présente encore des limitations :

- en premier lieu, le choix de la commande par grille Schottky entraîne deux inconvénients. Le premier est du type technologique. La couche active étant de très faible épaisseur, il est délicat d'y adjoindre une grille sur le flanc de la mésa du transistor. Le deuxième inconvénient est relatif à la loi de variation du courant source-drain en fonction de la tension grille. Cette variation, qui est liée au gain du transistor, est plus faible pour une commande par grille Schottky que pour d'autres types de commande, par exemple par effet tunnel.

- en second lieu, du fait de la faible épaisseur de la couche N une faible tension drain-source ou drain-grille y crée un champ élevé qui peut atteindre le champ de claquage du matériau. Cette limitation dans la tension drain entraîne une limitation de la puissance du transistor.

L'objet de la présente invention est de pallier ces inconvénients en :

- choisissant un mode de commande de charge qui donne une grande variation de courant collecteur-émetteur en fonction de la tension de base ;

- en accroissant la tension collecteur.

On considérera donc successivement les deux aspects, commande de charge et tension collecteur.

Les transistors, selon l'invention, ont une structure verticale et fonctionnent en régime balistique comme ceux décrits dans la demande de brevet n° 80.23 385. Cependant ils comportent, en plus, intercallée entre la couche $N^+$ de l'émetteur et la couche active N, une première couche de semiconducteur de haute résistivité formant avec ces dernières une première hétérojonction de telle sorte que le transfert électronique à travers ces hétérojonctions soit en régime d'électrons chauds : effet tunnel ou effet thermoionique ou les deux effets combinés.

Selon un perfectionnement à l'invention, les transistors comportent en outre, intercallée entre la couche $N^+$ du collecteur et la couche active N, une deuxième couche de semiconducteur de haute résistivité formant avec ces dernières une deuxième hétérojonction.

De façon plus précise, l'invention concerne un transistor à effet de champ à multiples hétérojonctions, comportant, supportées par un substrat, une pluralité de couches de matériaux semiconducteurs ainsi que deux électrodes d'accès dites d'émetteur et de collecteur et une électrode de commande dite de base, ces électrodes étant en contact ohmique avec celles des couches qui forment les régions d'émetteur, de base et de collecteur, ce transistor étant caractérisé en ce que la région d'émetteur est constituée par deux couches de matériau semiconducteur présentant entre elles une hétérojonction permettant d'injecter des électrons chauds dans la base, en contact avec la seconde couche de l'émetteur.

L'invention sera mieux comprise et d'autres caractéristiques apparaîtront, au moyen de la description qui suit et les dessins qui l'accompagnent, parmi lesquels :

- la figure 1 représente le schéma de bandes d'un premier type de double hétérojonction à l'équilibre ;

- la figure 2 représente le schéma des bandes de conduction de cette structure sous polarisation ;

- la figure 3 représente le schéma de bandes d'un second type de double hétérojonction à l'équilibre ;

- la figure 4 représente le schéma des bandes de conduction de cette deuxième structure sous polarisation ;

- la figure 5 représente le schéma des bandes de conduction d'une hétérostructure formant la base et le collecteur d'un transistor selon l'invention ;

- la figure 6 représente le schéma des bandes de conduction d'une première structure de transistor selon l'invention ;

- la figure 7 représente le schéma des bandes de conduction d'une autre structure de transistor selon l'invention ;

- la figure 8 représente une coupe schématique d'un transistor selon l'invention ; .

- la figure 9 représente une coupe schématique d'une première variante du transistor selon l'invention ;

- les figures 10 à 12 représentent trois autres variantes du transistor selon l'invention.

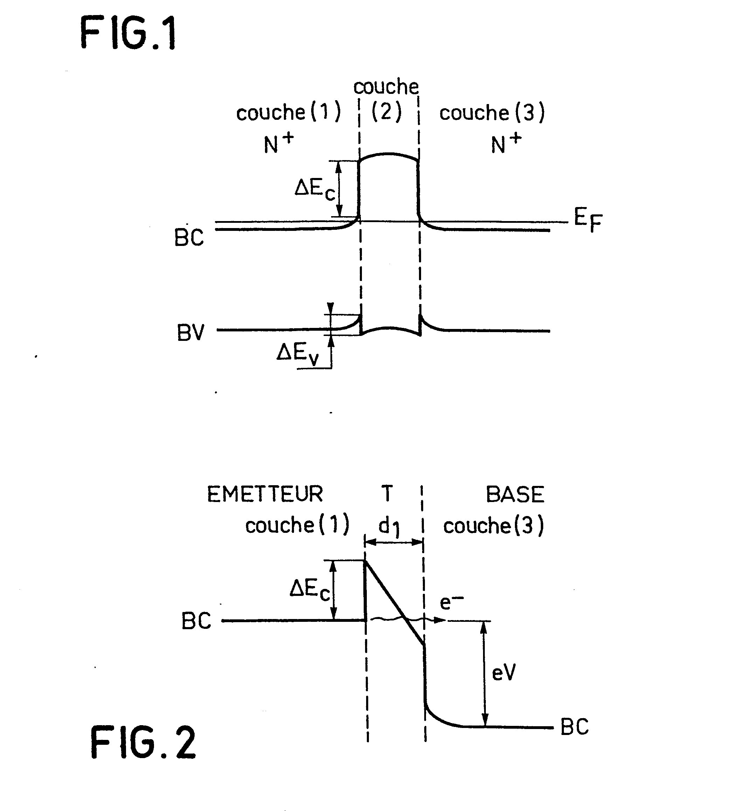

La figure 1 représente schématiquement le diagramme de bandes à l'équilibre d'une double hétérojonction. Celle-ci est formée par une couche 1 constituée par un matériau semiconducteur de type $N^+$ dopé $N > 5.10^{17} e/cm^3$, et une couche 2 constituée par un semiconducteur de haute résistivité présentant une bande interdite plus grande que le premier semiconducteur et le même paramètre de maille. Une couche 3 est formée du même matériau semiconducteur que le premier et est aussi fortement dopée $N > 5.10^{17} e/cm^3$. L'ensemble de l'hétérostructure est réalisable par épitaxie, par exemple l'épitaxie par jets moléculaires. BC, BV et $E_F$ désignent respectivement la bande de conduction, la bande de valence et le niveau de Fermi. $\Delta E_C$ et $\Delta E_V$ sont respectivement les discontinuités dans les bandes de conduction et de valence à l'interface. $\Delta E_C$ constitue une barrière de potentiel pour les électrons et $\Delta E_V$ une barrière pour les trous. Comme les couches 1 et 3 sont dopées de type N, seuls les électrons seront considérés.

La figure 2 représente schématiquement la position des bandes de conduction (les bandes de valence ne sont pas représentées) lorsqu'une tension V est appliquée entre les deux couches 1 et 3. Si la hauteur de barrière $\Delta E_C$ n'est pas trop grande et que l'épaisseur $d_1$ de la couche 2 n'est pas trop forte, des électrons peuvent traverser la barrière T de la couche 2 par effet tunnel. La probabilité de traverser la barrière T de potentiel par effet tunnel est donnée par l'expression :

$$T = \exp\left(-\frac{4d\sqrt{2m^*}\ E_C{}^{3/2}}{3q\hbar\ V}\right)$$

où $\hbar$ est la constante de Planck

m est la masse effective de l'électron

q est la charge de l'électron

V est la tension appliquée.

Les couches 1 et 2 constituent l'émetteur et la couche 3 la base du transistor selon l'invention qui sera décrit ultérieurement.

D'après la figure 2, à la sortie de la barrière de potentiel, l'énergie des électrons est eV. L'importance de la considération de cette énergie sera décrite plus tard.

Le choix approprié de la hauteur de barrière et de son épaisseur permettra de fixer le courant émetteur dont la loi de variation avec la tension de base appliquée est donnée par l'équation citée plus haut. C'est une variation exponentielle, dont la transconductance est très forte.

Le contact électrique de base est du type ohmique tel que l'on connaît déjà dans les transistors bipolaires. Il sera décrit ultérieurement.

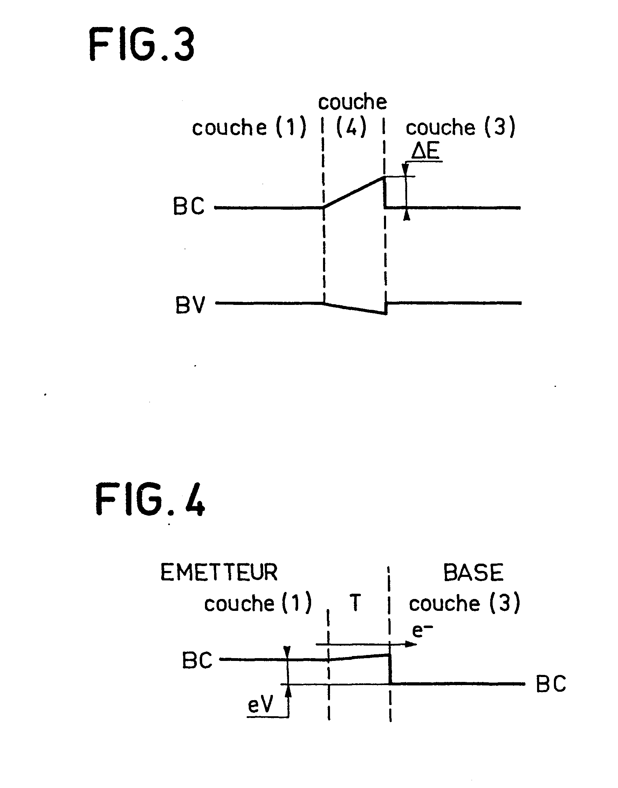

La figure 3 représente schématiquement le diagramme de bandes d'une double hétérojonction formée par une couche 1, une couche 4 et une couche 3. Les couches 1 et 3 sont identiques à celles déjà décrites à l'occasion de la figure 1. La couche 4 est de haute résistivité. Elle diffère de la couche 2 de la figure 1 en ce que sa composition est variable de manière à former une barrière de potentiel triangulaire à l'équilibre, la partie la plus haute de la barrière étant en contact avec la couche 3.

La figure 4 représente les bandes de conduction de cette double hétérojonction sous polarisation positive de la base 3. Pour une polarisation V telle que eV $\simeq$ E, les électrons traversent la barrière par effet thermoionique. Les électrons sont donc injectés dans la base avec une énergie $\Delta E$, ou très proche de $\Delta E$, car un effet tunnel assisté par effet thermoionique est possible. Le passage de courant à travers une barrière triangulaire telle que décrite, a été déjà mentionné dans la littérature (C.L. Allyn, A.C.

Gossard and W. Wiegmann, Appl. Phys. Letters 36, n° 5, 373 (1981)), cependant son utilisation dans une structure de transistor n'a pas été envisagée. Les données de la littérature montrent que le courant injecté dans le base suit une loi quasi exponentielle en fonction de V.

Pour simplifier l'écriture on désignera par $\Delta E_1$ la hauteur de barrière de potentiel à l'émetteur, quelle que soit la structure considérée.

La jonction émetteur-base d'un transistor selon l'invention a été décrite à l'occasion des figures 1 à 4. En ce qui concerne la jonction base-collecteur, le collecteur est constitué par deux couches 5 et 6 formant avec la couche 3 une hétérojonction présentant une barrière de potentiel $\Delta E_2$, de telle manière que la couche 5 de haute résistivité soit en contact avec la base 3 et que la barrière de potentiel de hauteur $\Delta E_2$ que constitue la couche 5 par rapport aux couches 3 et 6 soit suffisamment haute et/ou d'épaisseur $d_2$ suffisamment grande pour qu'un courant tunnel entre la base 3 et la couche 6 soit négligeable sous une tension donnée. Le dopage de la couche 6 est supérieur à $5.10^{17} e/cm^3$.

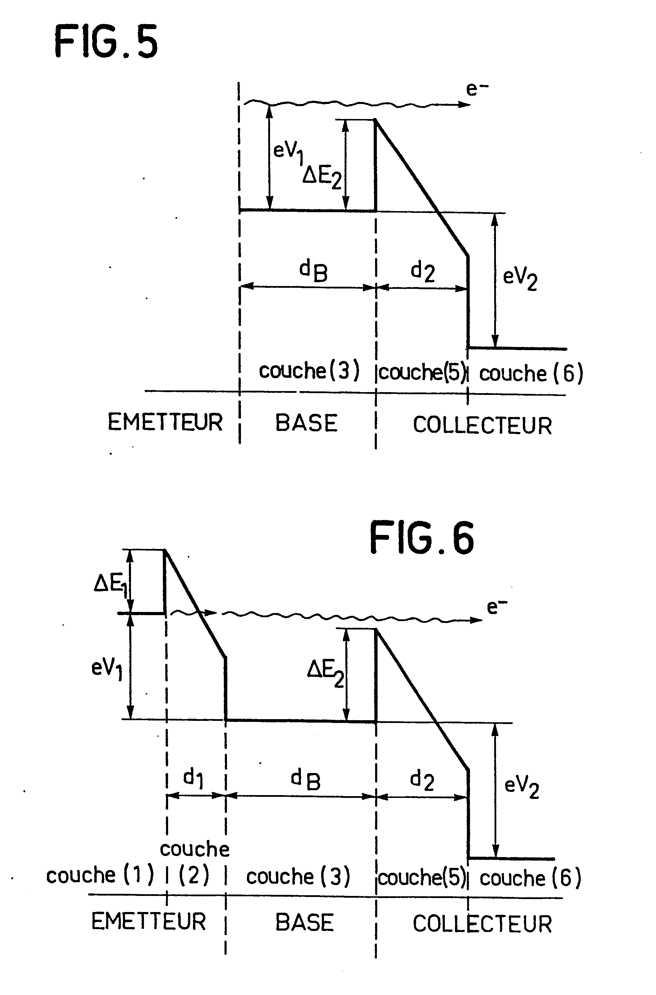

La figure 5 représente le schéma de bandes d'une telle structure base-collecteur sous polarisation $V_2$ entre base et collecteur. Sur cette figure l'émetteur est représenté sous la forme d'une jonction à partir de laquelle des électrons chauds sont injectés dans la base. L'énergie des électrons injectés est $eV_1$. Si $eV_1 > \Delta E_2$ et que l'épaisseur $d_B$ de la base est suffisamment faible pour que le parcours balistique des électrons soit possible à travers la base, ces électrons peuvent traverser la barrière $\Delta E_2$. Le terme balistique est pris ici dans le sens le plus général, incluant l'effet de survitesse. Autrement dit, même si les électrons perdent une certaine quantité d'énergie par chocs, ils peuvent traverser quand même la barrière $\Delta E_2$ à condition que l'énergie cinétique perdue soit inférieure à $eV_1 - \Delta E_2$.

Si l'ensemble des épaisseurs $d_B + d_2$ est faible, les électrons traversent aussi la couche 5 par effet balistique sinon leur vitesse décroît dans cette zone pour atteindre la vitesse limite $v_{stat.}$. Il est remarquable que le champ dans la base est très faible ; par conséquent, durant la traversée de la base, les électrons n'acquièrent pas de vitesse supplémentaire ; par contre, ils peuvent en perdre comme il a été précisé plus haut.

Jusqu'à présent, les différentes valeurs de hauteurs de barrière, de tensions de polarisation et d'épaisseur de couches épitaxiales, n'ont pas encore été spécifiées. Elles vont l'être dans ce qui suit.

Pour des applications de puissance en hyperfréquence, il est utile d'appliquer une tension élevée entre émetteur et collecteur ou entre base et collecteur. Il est donc nécessaire que la couche 5 constitue une barrière de potentiel très faiblement transparente à l'effet tunnel : $\Delta E_2$ et $d_2$ doivent être aussi grands que possible. Comme il a été dit plus haut, si $d_2$ est grand, les électrons n'y sont pas en parcours balistique. Leur vitesse y est limitée à $v_{stat.}$. Le temps de charge du collecteur est alors plus élevé que dans le cas où $d_2$ est faible, ce qui réduit la fréquence de coupure du transistor. Mais, compte tenu du fait que la fréquence de coupure dépend d'autres éléments parasites (résistances d'accès, capacités, ...), la limite supérieure de $d_2$ peut être de 1 $\mu$m environ. La limite inférieure de $d_2$ dépend de la valeur de $\Delta E_2$. D'après l'équation citée cette dépendance suit la loi de $d_2 \Delta E_2^{3/2}$, pour une tension appliquée donnée et un courant de fuite tunnel donné. Dans la pratique $\Delta E_2 < 1$ eV (à cause du choix des couples d'hétérojonction) et pour des tensions de l'ordre du volt et plus, $d_2$ doit être supérieure à 400 Å. La limite inférieure de $\Delta E_2$ est conditionnée par l'effet tunnel assisté par effet thermoionique. Dans la pratique il faut que $\Delta E_2 > 0,2$ eV.

Il faut donc que la tension base-émetteur soit supérieure à 0,2 V. Mais cette seule considération de l'énergie n'est pas suffisante. Il faut que le courant injecté soit aussi important que possible à la fois pour augmenter la puissance et pour réduire la résistance d'accès. Deux types d'émetteur sont à considérer séparément :

- Injection thermoionique : une hauteur de barrière supérieure ou égale à 0,2 eV convient.
- Injection tunnel : un choix peut être fait entre une faible barrière $\Delta E_1$ ou une faible épaisseur $d_1$. Dans la pratique on remarque que lorsque $d_1$ est inférieure à 100 Å la maîtrise du courant tunnel est difficile, donc $d_1 > 100$ Å. La limite inférieure de $\Delta E_1$ est 0,2 eV, comme pour $\Delta E_2$.

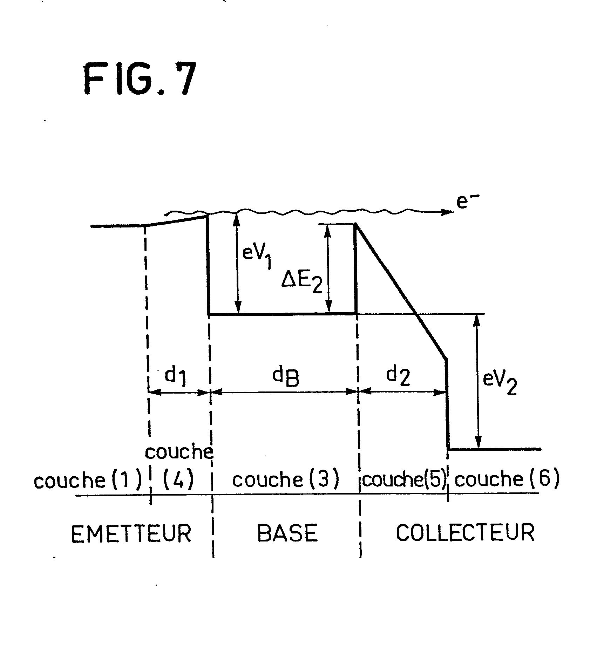

La figure 6 représente le diagramme de bandes de l'ensemble émetteur, base, collecteur sous polarisations, l'émetteur étant conststitué par les couches 1 et 2 (effet tunnel). La figure 7 représente le cas où l'émetteur est constitué par les couches 1 et 4 (effet thermoionique).

Une structure analogue à celle qui est représentée sur la figure 6 a été proposée récemment (M. Heiblum, Solid State Electronics 24, 343 (1981)). Mais les épaisseurs proposées pour les couches 3 et 5 sont respectivement de 80 Å et 120 Å. Une telle structure ne fonctionne donc pas dans les mêmes conditions, pour les raisons exposées plus haut.

Le tableau suivant spécifie les différents matériaux semiconducteurs utilisables. Ils sont divisés en trois groupes.

A l'intérieur de chaque groupe, les semiconducteurs des couches 1, 3 et 6 sont déterminés. La deuxième colonne énumère les semiconducteurs des couches 2 et 5. La troisième colonne énumère les semiconducteurs de la couche 4. Il est bien entendu que la couche 4 à composition variable peut être utilisée à la place de la couche 2 à composition constante, que les semiconducteurs 2 et 5 peuvent être différents en composition chimique, et que chaque matériau de la troisième colonne peut être associé à n'importe quel matériau de la deuxième colonne correspondant à la couche 5.

| | Semiconducteur (1)(3)(6) | Semiconducteur (2)(5) | Semiconducteur (4) |
|---|---|---|---|
| Groupe 1 | GaAs | $Al_x Ga_{1-x} As$ | $Al_{x'} Ga_{1-x'} As$ |
| | " | $Ga_x In_{1-x} P$ | $Ga_{x'} In_{1-x'} P$ |
| | " | $Al_x In_{1-x} P$ | $Al_{x'} In_{1-x'} P$ |
| | " | $AlP_x Sb_{1-x}$ | $AlP_{x'} Sb_{1-x'}$ |
| | " | $Al_x Ga_{1-x} P_y Sb_{1-y}$ | $Al_{x'} Ga_{1-x'} P_{y'} Sb_{1-y'}$ |
| | " | $Ga_x In_{1-x} P_y Sb_{1-y}$ | $Ga_{x'} In_{1-x'} P_{y'} Sb_{1-y'}$ |
| Groupe 2 | InP | $AlAs_x Sb_{1-x}$ | $AlAs_{x'} Sb_{1-x'}$ |
| | " | $AlP_x Sb_{1-x}$ | $AlP_{x'} Sb_{1-x'}$ |
| Groupe 3 | $Ga_x In_{1-x} As$ | InP | $Al_{x'} In_{1-x'} As$ |
| | " | $Al_x In_{1-x} As$ | $AlAs_{x'} Sb_{1-x'}$ |
| " | " | $AlAs_x Sb_{1-x}$ | $AlP_{x'} Sb_{1-x'}$ |
| | " | $AlP_x Sb_{1-x}$ | |

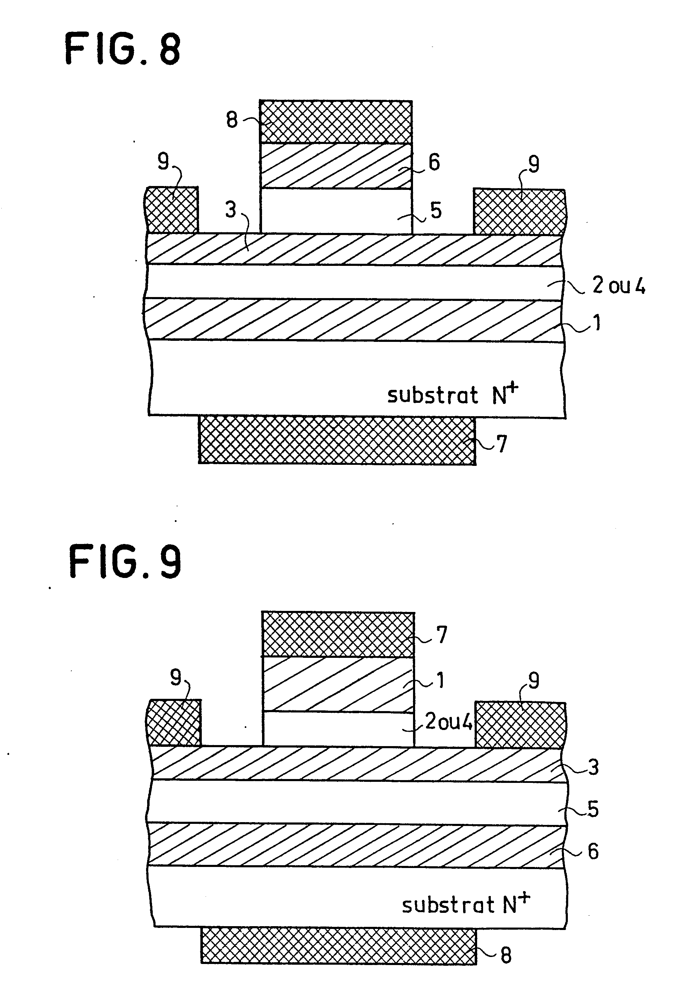

Les figures 8 à 13 représentent schématiquement différentes variantes du transistor, selon l'invention, avec les contacts électriques émetteur, base et collecteur.

Sur la figure 8, qui représente une première structure selon l'invention, le substrat d'épitaxie est fortement dopé $N^+$. Sur ce substrat sont déposés, par exemple par épitaxie par jets moléculaires, successivement les couches 1, 2 ou 4, 3, 5 et 6. Une mésa est dégagée dans les couches 5 et 6 de

9

collecteur jusqu'à la couche 3 de base afin d'y déposer le contact ohmique 9 de base. Le contact ohmique 7 d'émetteur est déposé sur la face libre du substrat, éventuellement aminci, pour réduire les résistances parasites, tandis que le contact 8 de collecteur est déposé sur la couche 6.

La figure 9 représente, en coupe schématique très simplifiée, une première variante d'un transistor selon l'invention. Par rapport à la structure de la figure précédente, l'ordre d'épitaxie des couches est inversé, de sorte que le collecteur est au substrat, les couches 5 et 6 étant enterrées, tandis que l'émetteur (couches 1 et 2 ou 4) est sur la face libre d'accès du transistor. Seule la couche 3 de base et sa métallisation 9 demeurent dans la même position que dans la structure de la figure précédente.

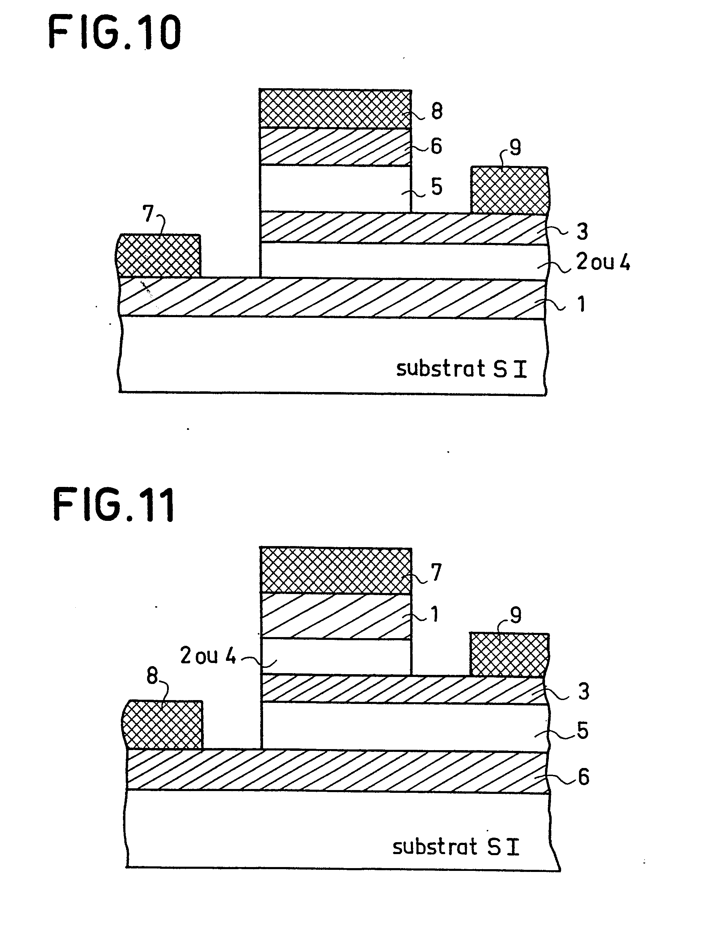

La figure 10 représente l'adaptation de la structure de la figure 8 dans le cas où le substrat n'est plus de type $N^+$, c'est-à-dire conducteur, mais est de haute résistivité, de type semi-isolant. L'ordre d'épitaxie des couches étant le même que dans le cas de la structure de base de la figure 8, il n'est plus possible de prendre le contact 7 d'émetteur sur la face libre du substrat, puisque celui-ci est semi-isolant. C'est pourquoi une seconde mésa est pratiquée, jusqu'à la couche 1, sur laquelle est déposée une métallisation 7, le contact 9 de base étant, comme dans les autres cas, obtenu à l'issue d'une mésa jusqu'à la couche 3.

La figure 11 représente l'adaptation de la première variante de la figure 9 au cas où le substrat n'est plus de type $N^+$, mais de type semi-isolant. L'ordre d'épitaxie des couches y est donc inversé mais, dans ce cas, c'est le contact 8 de collecteur qui est déposé sur la couche 6, rendue accessible par la gravure d'une seconde mésa.

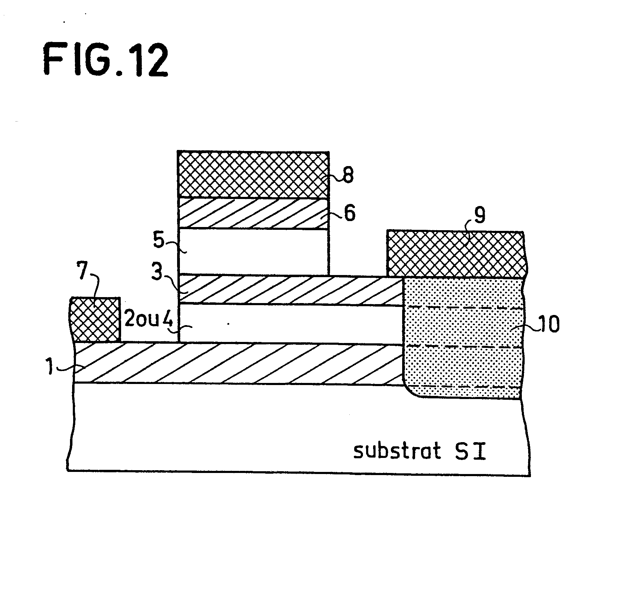

La figure 12 représente une amélioration au transistor selon l'invention, applicable aux différentes variantes décrites, bien que la structure représentée soit celle de la figure 10, sans pour autant être limitative. Afin de réduire les capacités parasites émetteur-base, sous la métallisation 9 de base est réalisée une zone 10 rendue résistive par implantation, d'ions $H^+$ par exemple. La zone 10, ou caisson, a une profondeur suffisante pour atteindre le substrat.

L'invention n'est pas limitée par la description des quelques exemples d'application qui en a été faite, et qui pourrait être complétés par d'autres exemples évidents pour l'homme de l'art. Elle est précisée par les revendications suivantes.

## REVENDICATIONS

1. Transistor balistique à multiples hétérojonctions, comportant, supportées par un substrat, une pluralité de couches de matériaux semiconducteurs ainsi que deux électrodes d'accès dites d'émetteur et de collecteur et une électrode de commande dite de base, ces électrodes étant en contact ohmique avec celles des couches qui forment les régions d'émetteur, de base et de collecteur, ce transistor étant caractérisé en ce que la région d'émetteur est constituée par deux couches (1 + T) de matériau semiconducteur présentant entre elles une hétérojonction permettant d'injecter des électrons chauds dans la base (3), en contact avec la seconde couche (T) de l'émetteur.

2. Transistor balistique selon la revendication 1, caractérisé en ce que l'émetteur est constitué par une première couche (1) d'un premier matériau semiconducteur fortement dopé $N^+ > 5.10^{17} e/cm^3$ et par une seconde couche (2), de haute résistivité, d'un autre matériau semiconducteur ayant même paramètre de maille que le premier mais de largeur de bande interdite plus grande, la seconde couche (2) ayant une composition constante, une épaisseur supérieure à 100 Å et une hauteur de barrière de potentiel supérieure à O,2 eV par rapport à la première couche (1), l'injection d'électrons chauds de l'émetteur (1 + 2) vers la base (3) étant contrôlée par effet tunnel à travers la seconde couche (2).

3. Transistor balistique selon la revendication 1, caractérisé en ce que l'émetteur est constitué par une première couche (1) d'un premier matériau semiconducteur fortement dopé $N^+ > 5.10^{17} e/cm^3$ et par une seconde couche (4) de haute résistivité, d'un autre matériau semiconducteur ayant même paramètre de maille que le premier mais de largeur de bande interdite plus grande, la seconde couche (4) ayant une compositsion variable de manière que la hauteur de la barrière de potentiel croisse de zéro jusqu'à une valeur supérieure à 0,2 eV, depuis la jonction avec la première couche (1) jusqu'à la jonction avec la couche formant la base (3), l'injection d'électrons chauds de l'émetteur (1 + 4) vers la base (3) étant contrôlée par effet thermoionique à travers la seconde couche (4).

4. Transistor balistique selon l'une quelconque des revendications 1, 2 ou 3, caractérisé en ce que la base est constituée par une troisième couche (3) du même matériau que la première couche (1), de dopage supérieur à $5.10^{17}$ e/cm$^3$ et d'épaisseur suffisamment faible pour que les électrons chauds injectés à partir de l'émetteur (1 + 2) gardent suffisamment d'énergie pour franchir la barrière de potentiel que constitue l'hétérojonction avec le collecteur.

5. Transistor balistique selon l'une quelconque des revendications 1, 2 ou 3, caractérisé en ce que le collecteur est constitué par une sixième couche (6) faite du même matériau semiconducteur que la première couche (1), de dopage supérieur à $5.10^{17}$ e/cm$^3$, et d'une cinquième couche (5) de haute résistivité, d'épaisseur supérieure à 400 Å formée par un troisième matériau semiconducteur ayant même paramètre de maille que le premier mais dont la largeur de bande interdite est plus grande, et en ce que la cinquième couche (5) forme une barrière de potentiel infranchissable par effet tunnel ou effet thermoionique aux électrons chauds contenus dans la base, sous une tension base-collecteur supérieure à 1 volt.

6. Transistor balistique selon la revendication 5, caractérisé en ce que :

- les première, troisième et sixième couches 1, 3, 6 sont en GaAs ;

- les seconde et cinquième couches 2, 5 sont en l'un quelconque des alliages suivants parmi : $Al_xGa_{1-x}As$, $Ga_xIn_{1-x}P$, $Al_xIn_{1-x}P$, $AlP_xSb_{1-x}$, $Al_xGa_{1-x}P_ySb_{1-y}$, $Ga_xIn_{1-x}P_ySb_{1-y}$.

7. Transistor balistique selon la revendication 5, caractérisé en ce que :

- les première, troisième et sixième couches 1, 3, 6 sont en GaAs ;

- la cinquième couche 5 est en l'un quelconque des alliages suivants parmi : $Al_xGa_{1-x}As$, $Ga_xIn_{1-x}P$, $Al_xIn_{1-x}P$, $AlP_xSb_{1-x}$, $Al_xGa_{1-x}P_ySb_{1-y}$, $Ga_xIn_{1-x}P_ySb_{1-y}$ ;

- la deuxième couche 4 est en l'un quelconque des alliages suivants parmi : $Al_{x'}Ga_{1-x'}As$, $Ga_{x'}In_{1-x'}P$, $Al_{x'}In_{1-x'}P$, $AlP_{x'}Sb_{1-x'}$, $Al_{x'}Ga_{1-x'}P_{y'}Sb_{1-y'}$, $Ga_{x'}In_{1-x'}P_{y'}Sb_{1-y'}$.

8. Transistor balistique selon la revendication 5, caractérisé en ce que :

 - les première, troisième et sixième couches (l, 3, 6) sont en InP ;

 - les seconde et cinquième couche 2, 5, sont en l'un quelconque des alliages suivants parmi :$AlAs_xSb_{1-x}$, $AlP_xSb_{1-x}$.

9. Transistor balistique selon la revendication 5, caractérisé en ce que :

 - les première, troisième et sixième couches (l, 3, 6) sont en InP ;

 - la cinquième couche 5 est en l'un quelconque des alliages suivants parmi : $AlAs_xSb_{1-x}$, $AlP_xSb_{1-x}$ ;

 - la deuxième couche 4 est en l'un quelconque des alliages suivants parmi : $AlAs_{x'}Sb_{1-x''}$, $AlP_{x'}Sb_{1-x''}$.

10. Transistor balistique selon la revendication 5, caractérisé en ce que :

 - les première, troisième et sixième couches 1, 3, 6 sont en $Ga_xIn_{1-x}As$ ;

 - les deuxième et cinquième couches 2, 5 sont en l'un quelconque des alliages suivants parmi : InP, $Al_xIn_{1-x}As$, $AlAs_xSb_{1-x''}$, $AlP_xSb_{1-x}$.

11. Transistor balistique selon la revendication 5, caractérisé en ce que :

 - les première, troisième et sixième couches 1, 3, 6 sont en $Ga_xIn_{1-x}As$ ;

 - la cinquième couche 5 est en l'un quelconque des alliages suivants parmi : InP, $Al_xIn_{1-x}As$, $AlAs_xSb_{1-x}$, $AlP_xSb_{1-x}$ ;

 - la deuxième couche 4 est en l'un quelconque des alliages suivants parmi : $Al_{x'}In_{1-x'}As$, $AlAs_{x'}Sb_{1-x''}$, $AlP_{x'}Sb_{1-x''}$.

12. Transistor balistique selon la revendication 5, caractérisé en ce que les première, deuxième, troisième, cinquième et sixième couches sont déposées successivement sur un substrat conducteur de type $N^+$, la première couche (l) étant en contact avec le substrat, et en ce qu'une mésa est dégagée jusqu'à la troisième couche (3) de façon à y déposer un contact (9) de base, un contact (7) d'émetteur étant déposé sur la surface libre du substrat et un contact (8) de collecteur sur la sixième couche (6).

13. Transistor balistique selon la revendication 5, caractérisé en ce que les sixième, cinquième, troisième, deuxième, première couches 6, 5, 3, 2 ou 4, 1 sont déposées successivement sur un substrat conducteur de type $N^+$, la sixième couche (6) étant en contact avec le substrat et en ce qu'une mésa est dégagée jusqu'à la troisième couche (3), de façon à y déposer un contact électrique (9) de base, un contact électrique (7) d'émetteur étant déposé sur la première couche (1) et celui (8) de collecteur sur la surface libre du substrat.

14. Transistor balistique selon la revendication 5, caractérisé en ce que les première, deuxième, troisième, cinquième, sixième couches 1, 2, 4, 3, 5, 6 sont déposées successivement sur un substrat de haute résistivité appelé substrat semi-isolant, la première couche (1) étant en contact avec le substrat et en ce qu'une mésa est dégagée sur un des flancs jusqu'à la troisième couche (3) et sur un autre flanc jusqu'à la première couche (1) de façon à déposer d'un côté un contact (9) de base et d'un autre côté un contact (7) d'émetteur, un contact (8) de collecteur étant déposé sur la sixième couche (6).

15. Transistor balistique selon la revendication 5, caractérisé en ce que les sixième, cinquième, troisième, deuxième, première couches 6, 5, 3, 2, 4, 1 sont déposées successivement sur un substrat semi-isolant, la sixième couche (6) étant en contact avec le substrat semi-isolant, et en ce qu'une mésa est dégagée sur un des flancs jusqu'à la troisième couche (3) et sur un autre flanc jusqu'à la sixième couche (6) de façon à déposer d'un côté un contact (9) de base et d'un autre côté un contact (8) de collecteur, un contact (7) d'émetteur étant déposé sur la première couche (1).

16. Transistor balistique selon l'une quelconque des revendications 10 à 14, caractérisé en ce que la métallisation (9) de base est déposée sur une zone (10) rendue isolante par implantation d'ions, cette zone (10) pénètrant depuis la troisième couche (3) à travers les couches sous-jacentes jusqu'à l'intérieur du substrat.

# FIG.1

couche (1)
$N^+$

couche
(2)

couche (3)
$N^+$

$\Delta E_c$

BC

$E_F$

BV

$\Delta E_v$

# FIG.2

EMETTEUR
couche (1)

T
$d_1$

BASE
couche (3)

$\Delta E_c$

BC

$e^-$

$eV$

BC

# FIG.3

couche

couche (1) | (4) | couche (3)

$\Delta E$

BC

BV

# FIG. 4

EMETTEUR       BASE

couche (1)   T   couche (3)

e⁻

BC

BC

eV

# FIG.5

# FIG.6

# FIG. 7

$e^-$

$eV_1$

$\Delta E_2$

$eV_2$

$d_1$

$d_B$

$d_2$

couche (1) | couche (4) | couche (3) | couche (5) | couche (6)

EMETTEUR | BASE | COLLECTEUR

FIG. 8

FIG. 9

FIG.10

8
6
9
5
7
3
2 ou 4
1

substrat S I

FIG.11

7
1
2 ou 4
9
8
3
5
6

substrat S I

# FIG.12

substrat SI

Office européen
des brevets

**RAPPORT DE RECHERCHE EUROPEENNE**

EP   82 40 1122

## DOCUMENTS CONSIDERES COMME PERTINENTS

| Catégorie | Citation du document avec indication. en cas de besoin, des parties pertinentes | Revendication concernée | CLASSEMENT DE LA DEMANDE (Int. Cl. ³) |
|---|---|---|---|
| A | FR-A-2 394 174  (IBM) | | H 01 L   29/72 H 01 L   29/08 |
| | --- | | |
| E | EP-A-0 033 876  (IBM) * en entier * | 1-16 | |
| | ----- | | |

| DOMAINES TECHNIQUES RECHERCHES (Int. Cl. ³) |
|---|
| H 01 L   29 H 01 L   49 |

Le présent rapport de recherche a été établi pour toutes les revendications

| Lieu de la recherche LA HAYE | Date d'achèvement de la recherche 14-10-1982 | Examinateur PELSERS L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille. document correspondant

OEB Form 1503 03 82